# EUROPEAN PATENT SPECIFICATION

(11) **EP 3 013 485 B1**
(45) Date of publication and mention of the grant of the patent: **04.08.2021**
(21) Application number: 14849039.4
(22) Date of filing: 27.06.2014
(51) Int. Cl.: B32B 37/12, H01L 51/44, B29C 63/02, B32B 38/18

(54) **COATINGS FOR AIRCRAFT WINDOW SURFACES TO PRODUCE ELECTRICITY FOR MISSION-CRITICAL SYSTEMS ON MILITARY AIRCRAFT**
BESCHICHTUNGEN FÜR FLUGZEUGFENSTEROBERFLÄCHEN ZUR ERZEUGUNG VON ELEKTRIZITÄT FÜR MISSIONSKRITISCHE SYSTEME BEI EINEM KAMPFFLUGZEUG
REVÊTEMENTS POUR SURFACES DE FENÊTRES D'AVION DESTINÉS À PRODUIRE DE L'ÉLECTRICITÉ POUR DES SYSTÈMES INDISPENSABLES À UNE MISSION SUR UN AVION MILITAIRE

(30) Priority: 28.06.2013 US 201361841243 P; 28.06.2013 US 201361841247 P; 28.06.2013 US 201361841244 P; 28.06.2013 US 201361841248 P; 28.06.2013 US 201361841251 P; 02.07.2013 US 201361842365 P; 02.07.2013 US 201361842355 P; 02.07.2013 US 201361842357 P; 02.07.2013 US 201361842372 P; 02.07.2013 US 201361842375 P; 03.07.2013 US 201361842803 P; 03.07.2013 US 201361842796 P
(43) Date of publication of application: 04.05.2016
(73) Proprietor: SolarWindow Technologies, Inc., New York, NY 10022 (US)
(72) Inventor: CONKLIN, John Anthony, Apalachin, NY 13732 (US); HAMMOND, Scott Ryan, Wheat Ridge, CO 80215 (US); THOMPSON, Patrick J., Canton, GA 30114 (US)
(74) Representative: Qip Patentanwälte Dr. Kuehn & Partner mbB
(86) International application number: PCT/US2014/044644
(87) International publication number: WO 2015/047503

(56) References cited:
- WO-A1-2013/045466
- WO-A2-2012/154803
- US-A1- 2008 295 889
- US-A1- 2009 008 507
- US-A1- 2009 229 667
- US-A1- 2013 002 015
- US-B1- 8 448 898
- KALTENBRUNNER M ET AL: "Ultrathin and lightweight organic solar cells with high flexibility", NATURE COMMUNICATIONS, NATURE PUBLISHING GROUP, UNITED KINGDOM , 3 April 2012 (2012-04-03), pages 1-7, XP002682520, ISSN: 2041-1723, DOI: 10.1038/NCOMMS1772 Retrieved from the Internet: URL:http://www.nature.com/ncomms/journal/v 3/n4/full/ncomms1772.html [retrieved on 2012-04-03]
- None

## Description

### FIELD OF THE INVENTION

The present invention is directed to the use of semi-transparent organic photovoltaic devices - cell or modules - as coatings for military aircraft windows, including fighter and troop transport jet cockpits, to provide electricity for mission-critical systems on-board the aircraft.

### BACKGROUND OF THE INVENTION

Modern military aircraft are highly technologically advanced vehicles that must perform a variety of duties under very demanding conditions. Energy efficiency and energy consumption are of minimal concern in such vehicles, but the military is constantly looking to make every surface into an active one, through the use of advanced materials. Despite this, windows in military aircraft remain largely passive, non-functional surfaces. If value could be added to these windows by making them contribute to the overall mission-capability of the aircraft by producing electrical energy, it would be a significant improvement, regardless of cost US 2009/0229667 A1 does not disclose application of an electricity-generating coating onto a window surface of a military aircraft by means of a pressure-sensitive adhesive.

### SUMMARY OF THE INVENTION

SolarWindow™ is a novel photovoltaic window technology, based upon organic photovoltaics (OPV), that is the subject of several separate patent filings. This technology has numerous benefits, including the ability to generate power yet retain a high level of visible light transmission (VLT) in an attractive window application. To date, however, it has only been considered for a terrestrial application, generally in building-integrated photovoltaics (PV) applications. Very few PV technologies can be made inherently semi-transparent, and thus compatible with window technologies, and the few that can generally have very low VLT and poor aesthetics. For example, semi-transparent amorphous Silicon is generally red in appearance, with low VLT, which would be prohibitive for a military aircraft window application. OPV has a number of other inherent benefits for military aircraft applications including low specific weight (W/g), flexibility, and thickness of the thin films. An important feature is the very low specific weight of OPV, as compared to other PV technologies, and an inherent flexibility that allows unique application to non-planar surfaces, such as fighter and troop transport jet cockpit windows. Furthermore, the tunable nature of the absorption in OPV materials allows customized appearance and performance in semi-transparent window applications, which would allow performance to be optimized for different military aircraft window requirements.

The present invention recognizes that conventional military aircraft windows are generally strictly passive windows, which do not contribute actively to the mission-capability of the aircraft.

These problems and others are addressed by the present invention as defined in the appended claims. An exemplary embodiment of the electricity-generating coating can be applied as a coating to a conventional military aircraft window. The coating can be applied to either the exterior or interior of the aircraft window, depending on the desired properties, but the interior coating likely has significant benefits, including increased protection of the OPV module and easier electrical connections. In this embodiment, the OPV device can either be applied as a completed device onto the window surface using a thin, flexible substrate with pressure-sensitive adhesives, which is described in detail in Applicants' related application, or OPV device can be fabricated directly on the window through standard coating (e.g. spray, slot-die, curtain, gravure, etc.) and processing (e.g., laser scribing) techniques, as know to those skilled in the art of OPV. The OPV or SolarWindow™ device can provide electricity to help power mission-critical systems, while still retaining a high degree of VLT to ensure good visibility. Furthermore, the absorption properties of the OPV module can be selected to optimize the visual transmission properties of the window to match the aircraft's designed use, while still providing power.

Another exemplary embodiment of the invention can be applied as a coating to a conventional military fighter or troop transport jet cockpit canopy. Again, the coating may be applied to either the inside or the outside, with the inside having significant advantages, as described previously. In this embodiment, the OPV or SolarWindow™ device can again provide electricity to help power mission-critical systems, while still retaining a high degree of VLT to ensure good visibility. The absorption of the OPV module can be selected to yield optimal visual transmission properties of the window to aid in pilot perception and navigation, while still generating power. Furthermore, while the OPV device can be fabricated directly on the window through the use of complicated three-dimensional coating (e.g. spray, slot-die, curtain, gravure, etc. coating) and processing (e.g. laser scribing) methods, the inherent flexibility of OPV also presents the potential for application of the completed OPV device to the cockpit canopy through the use of thin, flexible substrates and pressure-sensitive adhesives, which is Applicants' related application.

Other features and advantages of the present invention will become apparent to those skilled in the art upon review of the following detailed description and drawings.

### BRIEF DESCRIPTION OF THE DRAWINGS

These and other aspects and features of embodiments of the present invention will be better understood after a reading of the following detailed description, together with the attached drawings, wherein:
Figure 1 is a cross-sectional view of a pressure-sensitive adhesive-coated, semitransparent organic photovoltaic device, itself coated on a thin flexible substrate with a transfer release layer and rigid backing layer, which can be used to prepare planar and curved organic photovoltaic device-covered military aircraft windows, according to an exemplary embodiment of this invention.
Figure 2 is a cross-sectional view of a semitransparent organic photovoltaic device coated onto a planar military aircraft window using the pressure-sensitive adhesive method according to an exemplary embodiment of the invention.
Figure 3 is a cross-sectional view of a semitransparent organic photovoltaic device coated directly onto a planar military aircraft window using conventional coating methods according to an exemplary embodiment of the invention.
Figure 4 is a cross-sectional view of a semitransparent organic photovoltaic device coated onto a curved military aircraft window using the pressure-sensitive adhesive method according to an exemplary embodiment of the invention.
Figure 5 is a cross-sectional view of a semitransparent organic photovoltaic device coated directly onto a curved military aircraft window using conventional coating methods according to an exemplary embodiment of the invention.

### DETAILED DESCRIPTION OF THE EXEMPLARY EMBODIMENTS OF THE INVENTION

The present invention now is described more fully hereinafter with reference to the accompanying drawings, in which embodiments of the invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art.

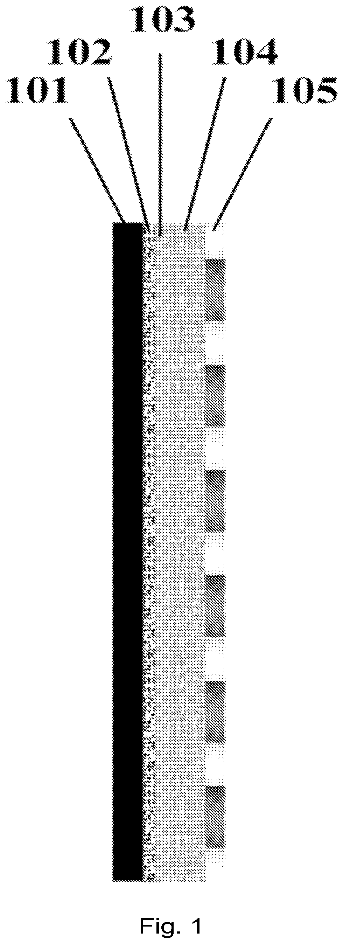

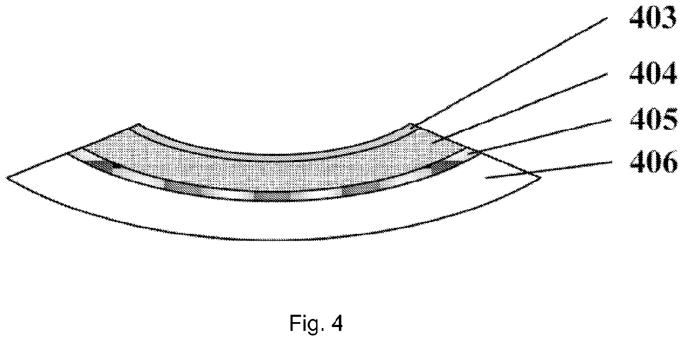

Referring now to the drawings, Figures 1-5 illustrate exemplary embodiments of electricity-generating coatings for military aircraft window surfaces (Figures 4-5) and their manufacture (Figure 1).

Referring to Fig. 1, which provides a cross-sectional view of an intermediate film stack produced for the eventual fabrication of electricity-generating coatings for military aircraft window surfaces, the film is prepared upon a temporary base layer 101, in order to provide sufficient rigidity to allow conventional manufacturing techniques, including high-speed roll-to-roll coating. The base layer can include thick polymer foils, metal foils, or any convenient substrate material, depending on the chosen manufacturing methods. On top of the base layer is a transfer release layer 102 that allows easy removal of the base layer and transfer layer from the thin flexible substrate 103, which are all laminated together as known to those skilled in the art. The thin flexible substrate is any appropriate substrate material that is highly flexible and transparent, such as very thin polymer foils, including but not limited to polyethyleneterephthalate (PET). On top of this is coated a semi-transparent OPV device, comprising one or more cells connected in series and/or parallel, which is inherently flexible and thus contains no highly crystalline materials. The multi-layered OPV device is coated and processed according to standard methods known to those skilled in the art, such as slot-die coating and laser scribing, which are compatible with high-throughput manufacturing techniques, including high-speed roll-to-roll or sheet-to-sheet production methods. Finally, the OPV device is coated on top with a semitransparent pressure-sensitive adhesive according to methods know to those skilled in the art. The resulting film comprising layers 101-105 can be used to transfer the semitransparent OPV device comprising layers 103-105 onto military aircraft windows to convert them into electricity-generating window surfaces.

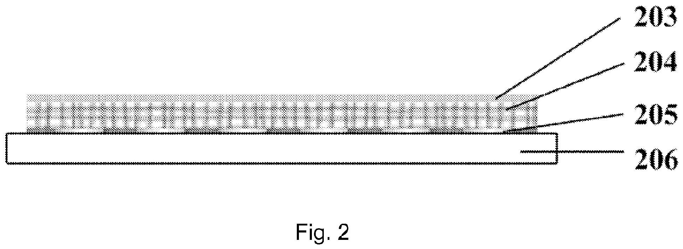

Referring to Fig. 2, which provides a cross-sectional view of a planar electricity-generating military aircraft window produced via the pressure-sensitive adhesive method, the base layer 206 comprises a conventional military aircraft window. Laminated onto the window using stretching and press-forming, with or without vacuum assistance in removing entrained air, is the electricity-generating semitransparent OPV device 204, which is adhered to the window using the pressure-sensitive adhesive layer 205, and is supported by the thin flexible substrate layer 203. While, in this exemplary embodiment, the method is necessarily a discrete object process for the fabrication of each individual window, the intermediate transfer film (see Fig. 1) used to transfer the completed OPV device onto the window can be produced in a continuous, high-throughput methodology. Not shown are any wires or other electrical contacts, or any power circuitry (e.g. inverters), which would be contained within the window casing or aircraft body, respectively, or any protective coatings that might be desirable.

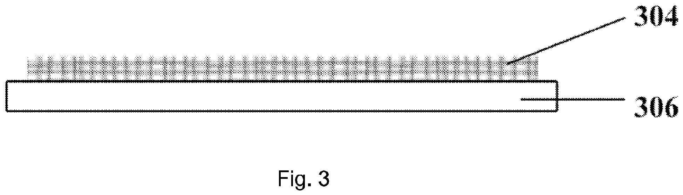

Referring to Fig. 3, which provides a cross-sectional view of a planar electricity-generating military aircraft window produced via the conventional coating method, the base layer 306 includes a conventional military aircraft window. The semitransparent OPV device 304 is coated directly onto the window surface using conventional coating techniques such as known to those skilled in the art. While this method has the advantage of having less extraneous layers and materials involved as compared to the laminated processes (see Fig. 2), in this exemplary embodiment, it is necessarily a sheet-to-sheet coating process performed on a window-by-window basis for every individual layer in the OPV device, which can limit throughput and increase defects, compared to producing the OPV device in a continuous process (see Fig. 1). Not shown are any wires or other electrical contacts, or any power circuitry (e.g. inverters), which would be contained within the window casing or aircraft body, respectively, or any protective coatings that might be desirable.

Referring to Fig. 4, which provides a cross-sectional view of a curved electricity-generating military aircraft window (e.g. cockpit window) produced via the pressure-sensitive adhesive method, the base layer 406 comprises a conventional curved military aircraft window (e.g. cockpit window). Laminated onto the window using stretching and press-forming, with or without vacuum assistance in removing entrained air, is the electricity-generating semitransparent OPV device 404, which is adhered to the window using the pressure-sensitive adhesive layer 405, and is supported by the thin flexible substrate layer 403. The unique and inherent flexibility of OPV devices allows lamination onto curved surfaces without significant disruption of device performance, and enables production of three-dimensional OPV devices that would be difficult to produce via conventional coating techniques due to realities of capillarity flow on curved surfaces. This method enables OPV devices to be laminated onto surfaces of arbitrary and changing curvature, which would be impossible via conventional solution coating techniques. While, in this exemplary embodiment, the method is necessarily a discrete object process for the fabrication of each individual window, the intermediate transfer film (see Fig. 1) used to transfer the completed OPV device onto the window can be produced in a continuous, high-throughput methodology. Not shown are any wires or other electrical contacts, or any power circuitry (e.g. inverters), which would be contained within the window casing or aircraft body, respectively, or any protective coatings that might be desirable.

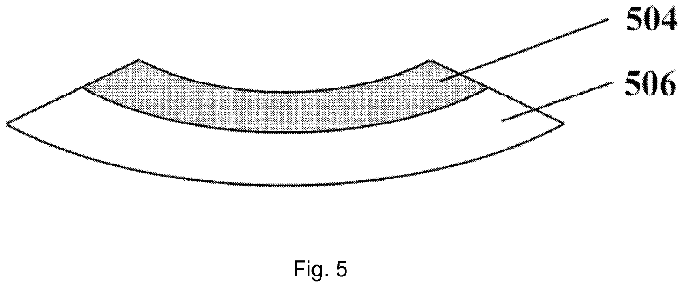

Referring to Fig. 5, which provides a cross-sectional view of a curved electricity-generating military aircraft window (e.g. cockpit window) produced via the conventional coating method, the base layer 506 includes a conventional curved military aircraft window (e.g. cockpit window). The semitransparent OPV device 504 is coated directly onto the window surface using conventional coating techniques such as spray or curtain coating. While the realities of capillarity flow make precision coating of such very thin layers very difficult, it is possible to overcome these limitations, as least for surfaces with relatively uniform curvature. Doing so repeated for the several layers in a semitransparent OPV device remains a significant challenge, however, and it is currently impossible for surfaces with varying or very high curvature using conventional practices. As such, the pressure-sensitive adhesive lamination method presents an attractive alternative for the production of curved windows (see Fig. 4).

The present invention has been described herein in terms of several preferred embodiments. However, modifications and additions to these embodiments will become apparent to those of ordinary skill in the art upon a reading of the foregoing description. It is intended that all such modifications and additions comprise a part of the present invention to the extent that they fall within the scope of the several claims appended hereto.

## Claims

1. An electricity-generating coating for a window surface (206, 306, 406, 506) of a military aircraft, the electricity-generating coating comprising:
a conformal organic photovoltaic device (104, 204, 304, 404, 504), including one or more cells connected in series and/or parallel, wherein the conformal organic photovoltaic device (104, 204, 304, 404, 504) is configured to be adhered to the window surface (206, 306, 406, 506) to convert the window surface into an electricity-generating window surface;
a pressure-sensitive adhesive (105, 205, 405) on the conformal organic photovoltaic device, the pressure-sensitive adhesive (105, 205, 405) being capable of adhering the conformal organic photovoltaic device (104, 204, 304, 404, 504) to the window surface (206, 306, 406, 506),
wherein the organic photovoltaic device (104, 204, 304, 404, 504) is semitransparent and the pressure-sensitive adhesive (105, 205, 405) is one of semitransparent and transparent such that light is capable of passing through the electricity-generating coating; and
a very thin, highly flexible transparent substrate (103, 203, 403),
wherein the conformal organic photovoltaic device (104, 204, 304, 404, 504) is covered by the very thin, highly flexible transparent substrate (103, 203, 403).

2. The electricity-generating coating of claim 1, wherein the conformal organic photovoltaic device (104, 204, 304, 404, 504) is protected by a transparent encapsulant material (103, 203, 403).

3. The electricity-generating coating of claim 2, wherein the window surface (206, 306, 406, 506) comprises a planar surface.

4. The electricity-generating coating of claim 2, wherein the window surface (206, 306, 406, 506) comprises a curved surface.

5. The electricity-generating coating of claim 1, wherein the conformal organic photovoltaic device (104, 204, 304, 404, 504) is configured to be coated directly on the window surface (206, 306, 406, 506).

6. The electricity-generating coating of claim 5, wherein the conformal organic photovoltaic device (104, 204, 304, 404, 504) is protected by a transparent encapsulant material (103, 203, 403).

7. The electricity-generating coating of claim 6, wherein the window surface (206, 306, 406, 506) is completely planar.

8. The electricity-generating coating of claim 6, wherein the window surface (206, 306, 406, 506) comprises a curved surface.

## Patentansprüche

1. Elektrizitätserzeugende Beschichtung für eine Fensteroberfläche (206, 306, 406, 506) eines Militärflugzeugs, wobei die elektrizitätserzeugende Beschichtung umfasst:
eine konforme organische photovoltaische Vorrichtung (104, 204, 304, 404, 504), die eine oder mehrere Zellen umfasst, die in Reihe und/oder parallel geschaltet sind, wobei die konforme organische photovoltaische Vorrichtung (104, 204, 304, 404, 504) dafür eingerichtet ist, an die Fensteroberfläche (206, 306, 406, 506) geklebt zu werden, um die Fensteroberfläche in eine elektrizitätserzeugende Fensteroberfläche umzuwandeln;
einen drucksensitiven Klebstoff (105, 205, 405) auf der konformen organischen photovoltaischen Vorrichtung, wobei der drucksensitive Klebstoff (105, 205, 405) in der Lage ist, die konforme organische photovoltaische Vorrichtung (104, 204, 304, 404, 504) an die Fensteroberfläche (206, 306, 406, 506) zu kleben,
wobei die organische photovoltaische Vorrichtung (104, 204, 304, 404, 504) semitransparent ist und der drucksensitive Klebstoff (105, 205, 405) entweder semitransparent oder transparent ist, dergestalt, dass Licht die elektrizitätserzeugende Beschichtung passieren kann; und
ein sehr dünnes, hochflexibles transparentes Substrat (103, 203, 403),
wobei die konforme organische photovoltaische Vorrichtung (104, 204, 304, 404, 504) durch das sehr dünne, hochflexible transparente Substrat (103, 203, 403) bedeckt ist.

2. Elektrizitätserzeugende Beschichtung nach Anspruch 1, wobei die konforme organische photovoltaische Vorrichtung (104, 204, 304, 404, 504) durch ein transparentes Verkapselungsmaterial (103, 203, 403) geschützt ist.

3. Elektrizitätserzeugende Beschichtung nach Anspruch 2, wobei die Fensteroberfläche (206, 306, 406, 506) eine planare Oberfläche umfasst.

4. Elektrizitätserzeugende Beschichtung nach Anspruch 2, wobei die Fensteroberfläche (206, 306, 406, 506) eine gekrümmte Oberfläche umfasst.

5. Elektrizitätserzeugende Beschichtung nach Anspruch 1, wobei die konforme organische photovoltaische Vorrichtung (104, 204, 304, 404, 504) dafür eingerichtet ist, direkt auf die Fensteroberfläche (206, 306, 406, 506) beschichtet zu werden.

6. Elektrizitätserzeugende Beschichtung nach Anspruch 5, wobei die konforme organische photovoltaische Vorrichtung (104, 204, 304, 404, 504) durch ein transparentes Verkapselungsmaterial (103, 203, 403) geschützt ist.

7. Elektrizitätserzeugende Beschichtung nach Anspruch 6, wobei die Fensteroberfläche (206, 306, 406, 506) vollständig planar ist.

8. Elektrizitätserzeugende Beschichtung nach Anspruch 6, wobei die Fensteroberfläche (206, 306, 406, 506) eine gekrümmte Oberfläche umfasst.

## Revendications

1. Revêtement générateur d'électricité pour surface de hublot (206, 306, 406, 506) d'un aéronef militaire, le revêtement générateur d'électricité comprenant :
un dispositif photovoltaïque organique conformé (104, 204, 304, 404, 504) comportant une ou plusieurs cellules connectées en série et/ou en parallèle, dans lequel le dispositif photovoltaïque organique conformé (104, 204, 304, 404, 504) est conçu pour adhérer à la surface de hublot (206, 306, 406, 506) afin de convertir la surface de hublot en une surface de hublot génératrice d'électricité ;
un adhésif sensible à la pression (105, 205, 405) sur le dispositif photovoltaïque organique conformé, l'adhésif sensible à la pression (105, 205, 405) étant apte à faire adhérer le dispositif photovoltaïque organique conformé (104, 204, 304, 404, 504) à la surface de hublot (206, 306, 406, 506),
dans lequel le dispositif photovoltaïque organique (104, 204, 304, 404, 504) est semi-transparent et l'adhésif sensible à la pression (105, 205, 405) est semi-transparent ou transparent, de manière que la lumière puisse passer à travers le revêtement générateur d'électricité ; et
un substrat transparent très mince, hautement flexible (103, 203, 403),
dans lequel le dispositif photovoltaïque organique conformé (104, 204, 304, 404, 504) est recouvert par le substrat transparent très mince, hautement flexible (103, 203, 403).

2. Revêtement générateur d'électricité, selon la revendication 1, dans lequel le dispositif photovoltaïque organique conformé (104, 204, 304, 404, 504) est protégé par un matériau d'enrobage transparent (103, 203, 403).

3. Revêtement générateur d'électricité, selon la revendication 2, dans lequel la surface de hublot (206, 306, 406, 506) comprend une surface plane.

4. Revêtement générateur d'électricité, selon la revendication 2, dans lequel la surface de hublot (206, 306, 406, 506) comprend une surface incurvée.

5. Revêtement générateur d'électricité, selon la revendication 1, dans lequel le dispositif photovoltaïque organique conformé (104, 204, 304, 404, 504) est conçu pour être appliqué directement sur la surface de hublot (206, 306, 406, 506).

6. Revêtement générateur d'électricité, selon la revendication 5, dans lequel le dispositif photovoltaïque organique conformé (104, 204, 304, 404, 504) est protégé par un matériau d'enrobage transparent (103, 203, 403).

7. Revêtement générateur d'électricité, selon la revendication 6, dans lequel la surface de hublot (206, 306, 406, 506) est complètement plane.

8. Revêtement générateur d'électricité, selon la revendication 6, dans lequel la surface de hublot (206, 306, 406, 506) comprend une surface incurvée.
